# EUROPEAN PATENT APPLICATION

(11) **EP 3 104 181 A1**
(43) Date of publication of application: **14.12.2016**
(21) Application number: 16173999.0
(22) Date of filing: 10.06.2016
(51) Int. Cl.: G01R 13/02

(54) **CIRCULATING RESAMPLING DIGITIZER**

(30) Priority: 12.06.2015 US 201514738611
(71) Applicant: Tektronix, Inc., Beaverton, Oregon 97077-0001 (US)
(72) Inventor: PICKERD, John, Hillsboro, OR 97123 (US)
(74) Representative: Clarke, Jeffrey David

(57) **Abstract**

Embodiments of the present invention provide improved techniques for sampling events in electrical test equipment such as real-time oscilloscopes. A circulating resampling digitizer uses a delay loop to repeatedly acquire replicas of an input event. The replicas are used to create a series of events which may be output or stored in memory. Signal reconstruction techniques such as interleaving and/or averaging may be applied to the series in order to construct a digital representation of the original input event. The resulting representation may have a higher sample rate, lower noise, and higher vertical resolution than each event in the series. The disclosed techniques use low cost components and can be added to existing instruments with little or no modification.

## Description

### FIELD OF THE INVENTION

The present invention relates to techniques for improving sample rate, noise, and bits of resolution in electrical test and measurement instruments.

### BACKGROUND OF THE INVENTION

Digital instruments such as real-time oscilloscopes use an analog-to-digital converter ("digitizer") to create a digital representation of an electrical input signal. The digitizer often limits the accuracy with which the signal can be captured. For example, the digitizer's sampling rate creates an upper limit on the signal frequencies that can be captured. The number of bits used in the digitizer limits the instrument's vertical resolution. The digitizer also adds some noise to the signal. In order to improve instrument accuracy, there is a need for improved sampling techniques that can increase the sample rate and vertical resolution of an instrument, while reducing noise.

Circulating delays have previously been used in optical instruments that do not operate in real time, such as sampling oscilloscopes. Due to their nature, sampling oscilloscopes can only process repetitive signals. Previous circulating delays were used to convert a single transient event into a repeated series of events, so that the sampling oscilloscope could process the transient event. None of the prior art, however, has combined a circulating delay with a real-time oscilloscope.

### SUMMARY OF THE INVENTION

Embodiments of the present invention provide enhanced sampling and event reconstruction circuits and methods for use with digital instruments. The disclosed circulating resampling digitizer ("CRD") receives an input signal, and creates two replicas of it. One replica is sampled while the other is sent through a delay loop. After the second replica passes through the delay loop the CRD creates two new replicas of it, one of which is sampled while the other is again sent through the delay loop. As a result, the digitizer has repeated opportunities to sample the same event, and is able to create a series of sampled events. The series of events can be processed to produce a representation of the original signal that has lower noise, increased vertical resolution, and/or an increased sample rate.

The objects, advantages, and other novel features of the present invention are apparent from the following detailed description when read in conjunction with the appended claims and attached drawings.

### BRIEF DESCRIPTION OF THE DRAWINGS

FIG. 1 is a high level block diagram of a circulating resampling digitizer and signal reconstruction block;
FIG. 2 depicts an exemplary embodiment of a circulating resampling digitizer;
FIG. 3 depicts a second exemplary embodiment of a circulating resampling digitizer;
FIG. 4 depicts a third exemplary embodiment of a circulating resampling digitizer;
FIG. 5 depicts a fourth exemplary embodiment of a circulating resampling digitizer;
FIG. 6 depicts a fifth exemplary embodiment of a circulating resampling digitizer;
FIG. 7 depicts a sixth exemplary embodiment of a circulating resampling digitizer;
FIG. 8 depicts a seventh exemplary embodiment of a circulating resampling digitizer;
FIG. 9 is a block diagram depicting an example of signal reconstruction using averaging;
FIG. 10 is a block diagram depicting an example of signal reconstruction using interleaving;
FIG. 11 is a block diagram depicting a second example of signal reconstruction using interleaving;
FIG. 12 is a block diagram depicting an example of signal reconstruction using both interleaving and averaging;
FIG. 13 depicts an exemplary embodiment of an oscilloscope using add-on CRD boxes.

### DETAILED DESCRIPTION OF THE INVENTION

As signal speeds increase, there is an ever-growing need for faster and more accurate instruments. Digitizers commonly create limits on a digital instrument's sample rate and vertical resolution, and add digitizer noise. Typically, these have been improved by using a digitizer with a faster sampling rate, more bits of resolution, or lower noise. But improved digitizers cannot be easily installed in older instruments. And even the best digitizers used in new instruments will still have sampling rate, resolution, and noise limitations. Thus, there is a need for improved sampling techniques that will enhance the instrument's sampling rate and vertical resolution while decreasing digitizer noise. Ideally, these techniques could be implemented by existing instruments without expensive modifications. Accordingly, embodiments of the present invention provide circuits and methods for a circulating resampling digitizer ("CRD") and associated signal reconstruction.

In one embodiment, the CRD receives an input signal and repeatedly loops it through a delay, sampling the signal every time it passes through the loop. This creates a stream of sampled events that may be stored in memory. Using this technique, a single transient signal may be resampled multiple times.

The sampled events may be used to create a digital representation of the original signal with lower noise, increased resolution, and/or a higher sample rate. Thereby improving some of the key performance metrics of real-time oscilloscopes. For example, averaging the events reduces the noise associated with each event while increasing the vertical resolution of the averaged result. Similarly, interleaving the events produces a result that has a higher sample rate than the individual events. These two techniques could also be combined. For example, by dividing the events into groups that are interleaved and averaging the interleaved results.

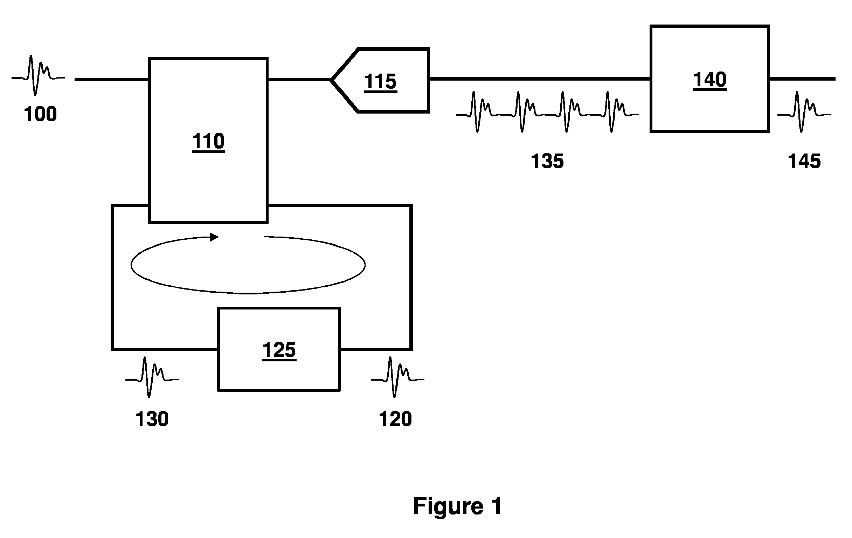

Figure 1 is a high-level block diagram of an exemplary circulating resampling digitizer (CRD) for use in a real-time instrument. Other components of the instrument, such as the power supplies, control lines, timebase, probes, etc., are not shown. In this embodiment, the CRD may consist of a coupling block **110,** digitizer **115,** delay block **125,** and signal reconstruction block **140.** An input event **100** is received by coupling block **110,** which sends event **100** to digitizer **115.** Digitizer **115,** which may be an existing digitizer in the instrument, samples event **100** and stores the sample in memory. Coupling block **110** also replicates event **100** and sends replica event **120** to delay block **125.**

Delay block **125** applies a time delay to event **120** and sends delayed event **130** back to coupling block **110.** Coupling block **110** treats delayed event **130** the same as input event **100,** sending delayed event **130** to digitizer **115** while creating another replica event **120.** Digitizer **115** samples delayed event **130** and concatenates it with the previous sample in memory. Thus, the CRD is able to convert a single input event **100** into a series of multiple events in memory, as represented by series **135** in Figure 1. This process may be repeated indefinitely, however losses in the system may limit the number of useful events that can be recorded.

Once the desired number of events have been recorded, signal reconstruction block **140** may process series **135** in order to create a representation **145** of input event **100.** Signal reconstruction block **140** may use techniques described below, such as interleaving and averaging the individual events in series **135.** The resulting representation **145** may have a higher sample rate and/or lower noise than each of the events in series **135.**

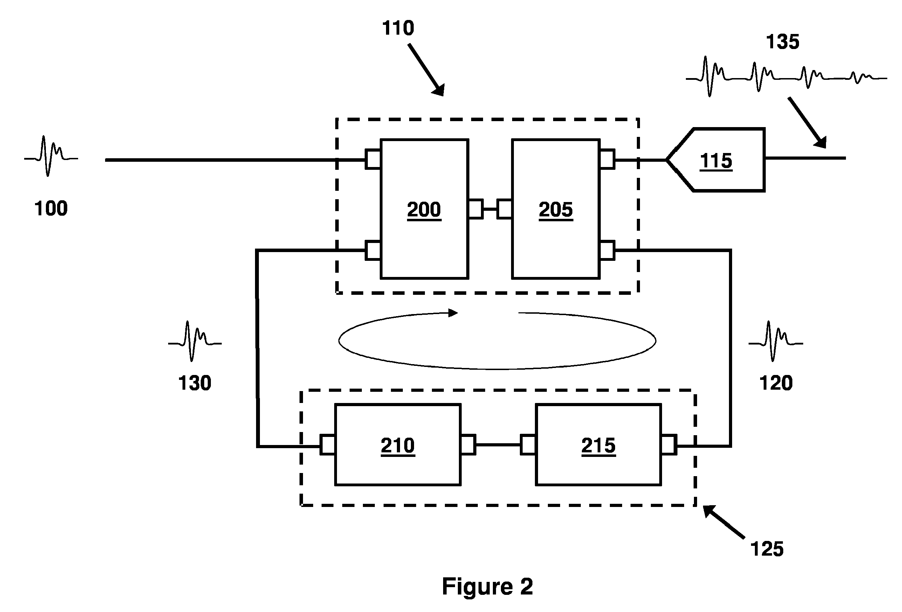

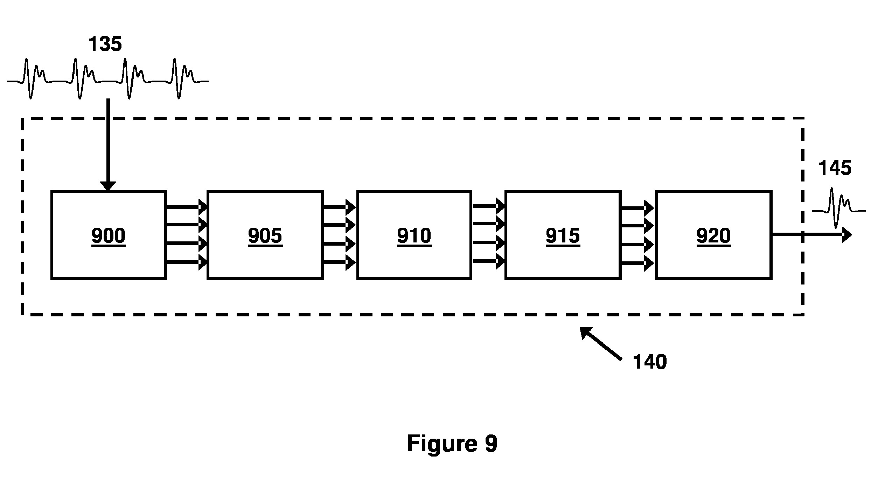

Decreasing the noise increases the signal-to-noise ratio, which in turn increases the vertical resolution of representation **145.** The effect is similar to increasing the number of bits in the digitizer, and may be measured as an effective number of bits. For example, averaging four events together may increase the vertical resolution by one effective bit. Exemplary embodiments of coupling block **110** and delay block **125** are shown in Figures 2-8. Figures 9-12 depict exemplary embodiments of signal reconstruction block **140.** Note that Figures 1-13 are not drawn as independent embodiments, and components shown in one Figure may also be used with embodiments shown in other Figures.

Figure 2 depicts an embodiment in which coupling block **110** comprises a combiner **200** and a divider **205.** Combiner **200** sends input event **100** or delayed event **130** to divider **205.** In some embodiments, combiner **200** may comprise a switch that sends only one of the inputs to divider **205.** In other embodiments, combiner **200** may consist of a device such as a power splitter that combines both of the inputs into a single output. In those embodiments, combiner **200** will effectively replicate an active signal on one of the inputs, as long as the other input is inactive. In this example, event **100** is assumed to be complete by the time delayed event **130** reaches combiner **200.**

Divider **205** receives the output from combiner **200** and creates two replica events on its outputs. In one embodiment, divider **205** and combiner **200** are both power splitters, such as Wilkinson power splitters. When a Wilkinson power splitter is used for combiner **200** or divider **205,** the magnitude of each combiner or divider output will be 3dB lower than its input. Other suitable coupling devices, however, could also be used for the combiner and/or divider. For example, directional couplers or resistive dividers could be used instead of power splitters. In some embodiments, a switch could be used for combiner **200,** as discussed below. Wilkinson power splitters may be preferred in some embodiments, since they typically have lower loss and higher isolation between their inputs and outputs than other devices. One drawback, however, is that Wilkinson power splitters do not provide isolation at low frequencies (around 1GHz and below). For embodiments in which input event **100** contains low frequencies, one or more isolators or amplifiers could be used to provide isolation at low frequencies, as discussed below. Alternatively, resistive dividers could be used in place of Wilkinson power splitters, since resistive dividers provide isolation at low frequencies. Resistive dividers, however, typically have twice the amount of loss as Wilkinson power splitters.

It is important that only one of events **100** or **130** is active at any point in time, so that coupling block **110** can replicate the active event without distortion. If both events are active at the same time, coupling block **110** will be unable to replicate either event accurately. Thus, it is important that delay block **125** delays event **120** long enough so that event **130** is not active until event **100** is complete. Event **100** may also be disconnected from combiner **200** or divider **205** before event **130** becomes active, as discussed below.

In one embodiment, delay block **125** consists of a single variable delay line **210.** In other embodiments, one or more fixed delay lines **215** may also be used. Variable delay line **210** may be adjusted to insure that successive recordings of event **130** do not have the same sample positions with respect to a reference position. The total delay in delay block **125** should be longer than event **100** to prevent distortion. Otherwise, input event **100** may still be active when event **130** reaches the coupling block.

The appropriate amount of delay may also depend on which signal reconstruction method is used. If interleaving will be performed, then the total delay time through the loop cannot be an exact multiple of the digitizer sample clock interval. Otherwise, the samples for each event will all occur at the same points, making interleaving impossible. For example, when two-way interleaving is used, delay block **125** may shift the samples for each delayed event by 1/2 of the input sample rate time interval. For 3- and 4-way interleaving, the delay may be adjusted by 1/3 and 1/4 of the input sample rate, respectively.

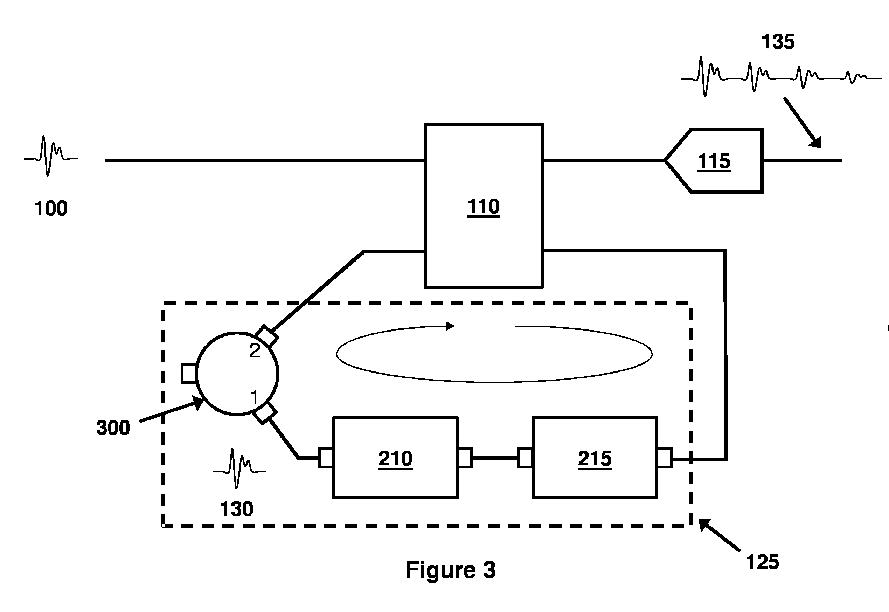

In some embodiments, one or more isolators may be used to prevent signals from traveling the wrong direction through the CRD. For example, Figure 3 depicts an embodiment in which isolator **300** is added to delay block **125.** One or more isolators may also be added to other portions of the CRD, such as to the input or outputs of coupling block **110.** The isolators allow signals to pass from port 1 to port 2, but reject signals that attempt to pass from port 2 to port 1 by as much as 20dB. Thus, isolator **300** reduces the likelihood of signals reflecting back and interfering with delayed event **130.** Existing isolators may have a center frequency anywhere from the MHz region up to 100 GHz, but generally do not cover a wide bandwidth. The widest bandwidth isolator currently known is 10 GHz. Thus, isolators may only be useful for narrow band applications. Amplifiers, however, have similar isolation properties and typically have much wider bandwidths. Thus, in one embodiment, one or more amplifiers may be used instead of isolators, as discussed below.

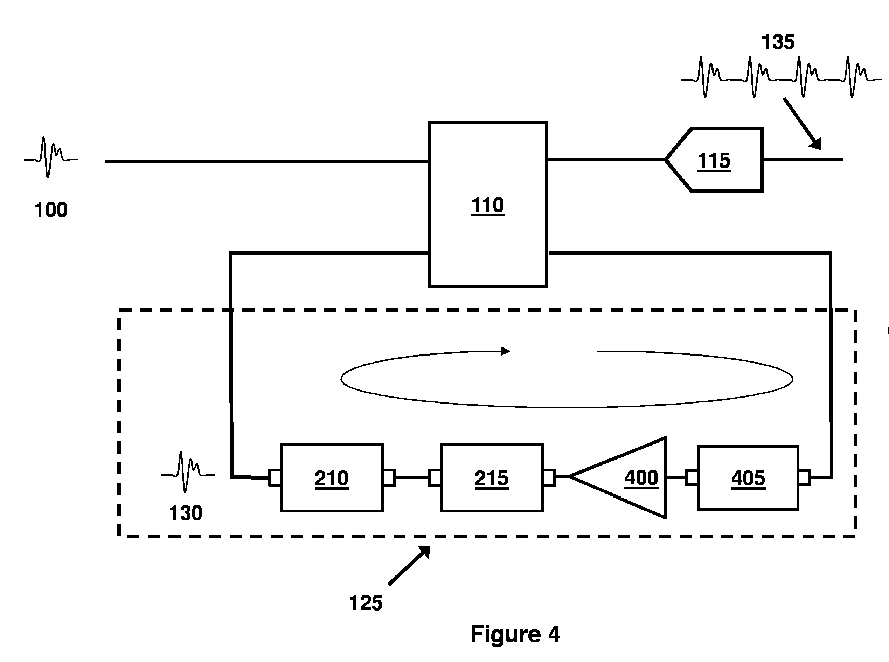

Amplifiers may also be used to compensate for component losses in the CRD. As depicted in Figure 4, one or more amplifiers **400** may be added to delay block **125** to compensate for losses caused by the coupling block and other components. These losses cause each successive event through coupling block **110** to be attenuated, which reduces the number of usable samples that can be recorded. This effect is represented in Figures 2 and 3 by the decreasing amplitudes shown in series **135.** Amplifier **400** allows the CRD to maintain a constant or near constant amplitude for each successive copy, as reflected by the constant amplitudes in series **135** of Figure 4. Note that the waveforms depicted in each figure are for illustration purposes only, and are not drawn to scale. One or more attenuators **405** may optionally be added, in order to match the low frequency capacitive coupling of amplifier **400.** This prevents low frequency reflections back into coupling block **110.** Amplifier **400** is not limited to the location shown in Figure 4 and may be placed in other locations, such as after variable delay line **210,** or in coupling block **110.**

The amplifier gain must be high enough to keep the amplitude of each event close to the previous event's amplitude, but low enough to maintain linear operation of the amplifier and prevent it from oscillating. Ideally, the gain will be slightly less than the total CRD system losses. To optimize the gain, one or more amplifiers and/or attenuators may be added to delay block **125** or coupling block **110.**

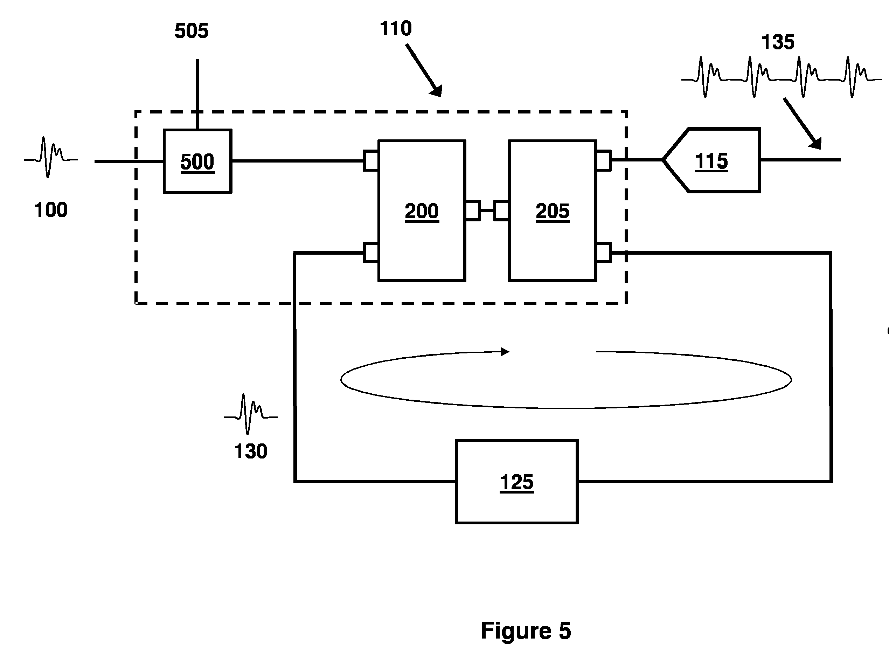

As discussed above, it may be desirable to disconnect input event **100** from the coupling block **110.** For example, when input event **100** is active for longer than the CRD delay, or does not return to its starting position (e.g., if event **100** is a step function). In these cases, disconnecting input event **100** will prevent delayed event **130** from being combined with event **100.** As shown in Figure 5, triggered gate **500** may be added to the input of coupling block **110.** Gate **500** may disconnect input event **100** based on trigger **505.** In one embodiment, trigger **505** consists of a one-shot multi-vibrator that has a pulse width less than the delay loop time, although other triggers may also be used.

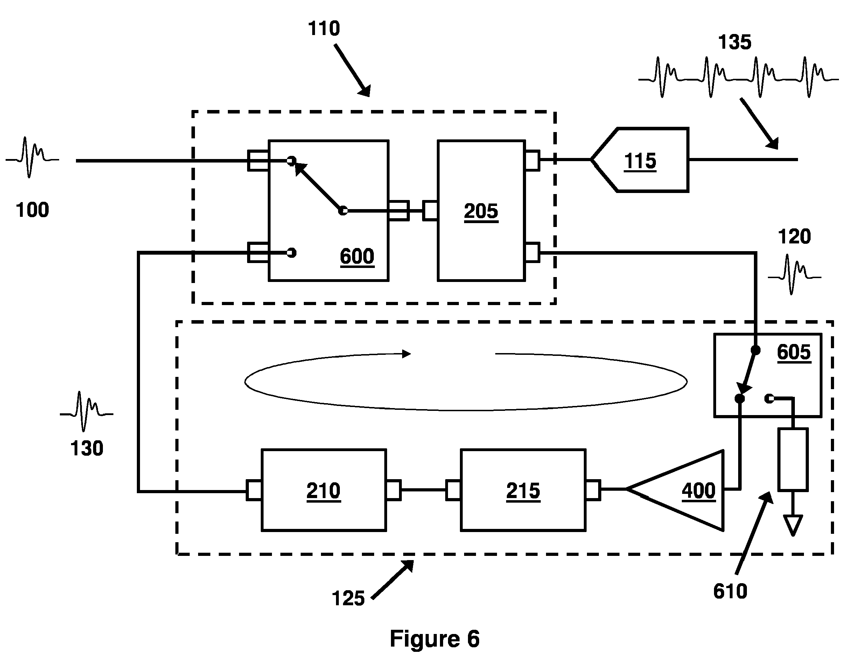

In an alternative embodiment, combiner **200** may comprise an input switch **600,** as shown in Figure 6. Input switch **600** may provide higher isolation and lower attenuation than other types of combiners, such as power splitters. Initially, input switch **600** connects divider **205** to event **100,** allowing divider **205** to replicate event **100.** Switch **600** will change and connect divider **205** to delayed event **130** before the delayed event reaches the coupling block. At the same time, input event **100** will be disconnected from divider **205.**

As long as input switch **600** connects divider **205** to event **130,** divider **205** will replicate successive copies of event **130.** Digitizer **115** records the successive copies fl and appends them to series **135.** Once the desired number of events have been digitized, switch **600** may reconnect divider **205** and event **100.**

In some cases, residual energy from event **120** or **130** may still be present when the next input event **100** occurs. This could cause digitizer **115** incorrectly record the new event **100** combined with the previous events **120** or **130.** To prevent this, a reset switch may be used to eliminate any residual energy in the delay loop.

As depicted in Figure 6, one or more reset switches **605** may be added to delay block **125.** Reset switch **605** is used to dissipate events **120** and **130** before the next input event **100** becomes active. In its normal position, reset switch **605** connects the output of coupling block **110** to the input of delay block **125.** When the desired number of samples have been recorded, or before the next input event **100** occurs, reset switch **605** provides a path to ground until events **120** and **130** have dissipated-for example through resistor **610.** After the events have dissipated, reset switch **605** re-connects coupling block **110** with delay block **125.** Reset switch **605** could also be located in coupling block **110,** for example as part of coupler **200** or divider **205.**

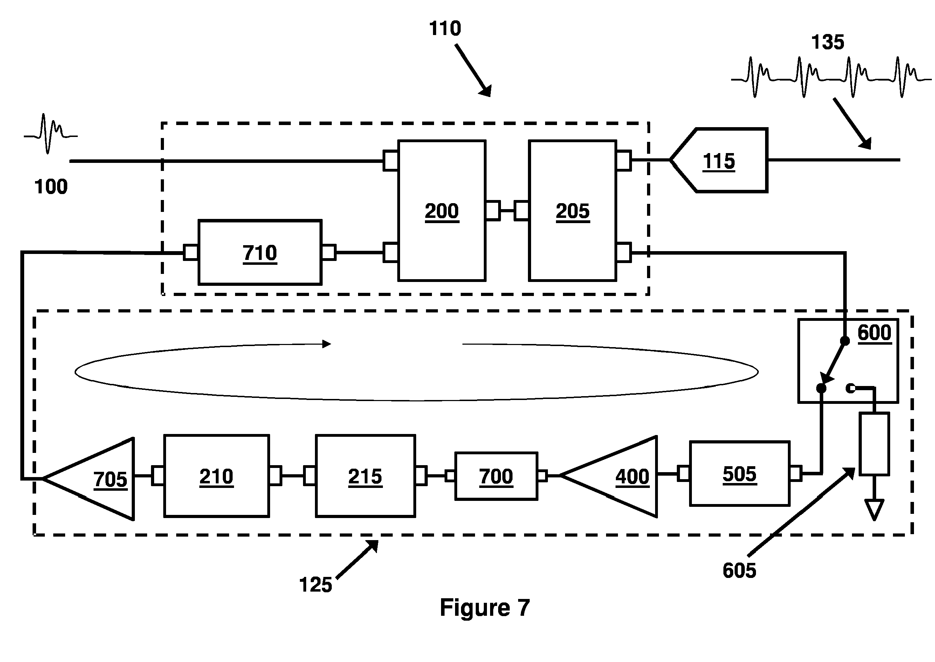

As discussed above, amplifiers may be used instead of isolators, to ensure that signals do not reflect back through the CRD. As shown in Figure 7, one or more amplifiers **705** may prevent signals from entering the delay loop from the wrong direction. One or more attenuators **710** may be used to compensate for the additional amplification. Because components in the CRD may attenuate high frequencies in the signal more than low frequencies, a pre-emphasis equalization circuit **700** may also be used to restore high frequencies in the delayed signal. Note that equalization circuit **700** may be installed in other locations, such as after variable delay line **210.**

As discussed above, events in series **135** may become distorted if the delay block **125** does not provide a long enough delay. A very long delay will allow the CRD to record longer events, and therefore a greater variety of events. But when the input event is short, this extra delay adds unnecessary processing time. This could cause the CRD to miss one or more input events if it is still processing the previous event. To prevent this, delay block **125** may adjust the amount of delay so that it is appropriate for each input.

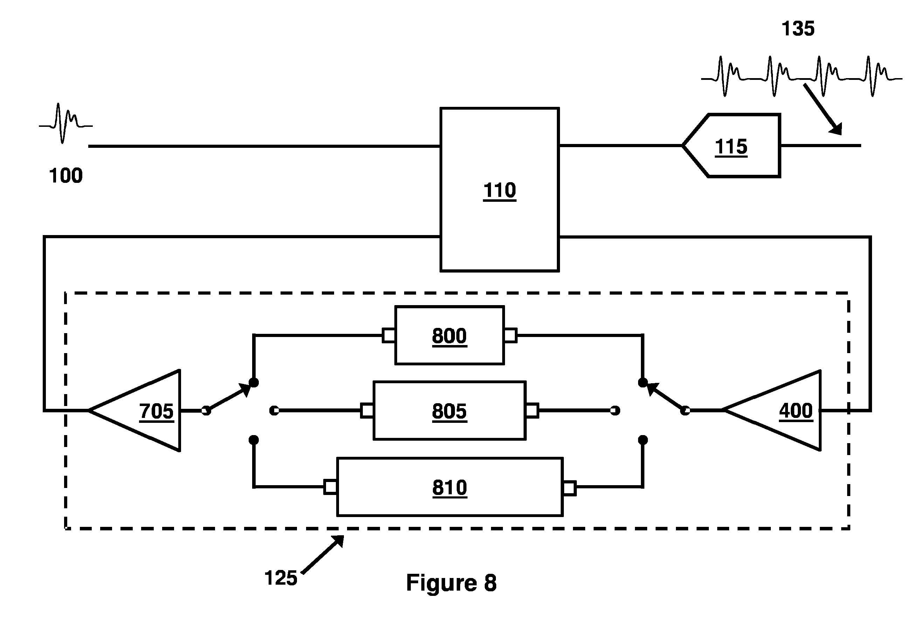

In one embodiment, variable delay line **210** may be adjusted to provide a range of different delays. Alternatively, delay block **125** may select between a number of delay lines that have different delays. As shown in Figure 8, for example, delay block **125** may comprise three variable delay lines **800, 805,** and **810.** Switches (unlabeled) in delay block **125** allow it to select one of the variable delay lines for a given input signal, in order to provide an appropriate delay. As discussed above, one or more fixed delay lines may also be used to further refine the amount of delay. One or more attenuators may also be used to fine tune the amount of gain in the system.

A person skilled in the art will understand that the embodiments shown in Figures 1-8 are not limiting, and that the depicted components may be added, omitted, or combined differently without departing from the scope of the invention.

After digitizer **115** produces event series **135,** signal reconstruction block **140** may reconstruct the original input event **100** by processing series **135** using an appropriate reconstruction technique. For example, Figure 9 depicts an example averaging technique. First, event separator **900** detects individual events in series **135** and separates each event into a unique output. For example, when there are four events in series **135,** event separator **900** will produce four outputs.

Event separator **900** may use any known method to separate the events. For example, event separator **900** may determine the position of each event in the series using autocorrelation to identify the intervals in which each event is centered. Additional methods could also be applied to further refine the positions. Event separator **900** may then use the position information to separate each individual event into a respective output.

Once the individual events have been separated, reconstruction block **140** may use known techniques such as averaging or interleaving to obtain representation **145.** One example of an averaging technique is shown in Figure 9, although other suitable averaging techniques known in the art may also be used.

In the averaging process depicted in Figure 9, EQ filter block may **905** correct the individual events for any distortion caused when recording series **135.** First, EQ filter block **905** determines transfer functions for each possible path through the CRD. Each event is then multiplied by the inverse of the appropriate transfer function for that event. For example, the notation H0 can represent the transfer function for passing through the CRD without entering the delay loop. Likewise, H1-H3 can denote the transfer functions for passing through the CRD after 1-3 trips through the delay loop, respectively. In this case, EQ filter block **905** would multiply the first event by the inverse of H0, since the first event passes through coupling block **110** without entering the delay loop. Likewise, EQ filter block **905** would multiply events 2-4 by the inverse of transfer functions H1-H3, respectively.

Reference position block **910** and resampling block **915** may be used to correct for any jitter between the various events. Reference position block **910** determines the amount of delay that must be applied to each event in order to align the events. For example, reference position block **910** may establish a time vs level reference position for each event and measure the time from that reference position to the sample clock position. Reference position block **910** may then align the events to the nearest integer position using a known technique.

In one embodiment, reference position block **910** aligns the events by taking a linear interpolation of samples on either side of the reference position. In another embodiment, reference position block **910** computes an FFT of the event data to determine a group delay, and uses the group delay to establish the amount of time shift for each event with respect to the reference group delay position.

Once the proper delay for each event has been determined, resampling block **915** may align the events. For example, resampling block **915** may compute a different all-pass filter for each event, based on the delay necessary to align that event. Resampling block **915** would then apply each filter to its respective event in order to align the events. This all-pass resampling could also be used in embodiments where interleaving is performed, to ensure that the time between interleaved samples is correct.

In another embodiment, resampling block **915** may align the events in the frequency domain, instead of the time domain. For example, resampling block **915** may perform a fast Fourier transform ("FFT") on the events to convert them into the frequency domain. The resampling block would then rotate the phases of each frequency-domain event, to align the event phases. This would effectively align the events in time, once they are converted back to the time domain. Resampling block **915** could then perform an inverse FFT on the phase-aligned events to convert them to the time domain.

After passing through resampling block **915,** the sample clocks for each event end up at the same point as the other events, relative to the reference position. Once the events have been resampled, averaging block **920** averages the events in order to obtain representation **145.** In one embodiment, averaging may be performed by summing the individual events and dividing by the total number of events (e.g., four).

As a result of the averaging process, representation **145** will have lower noise when compared to each of the sampled events in series **135.** Because the noise in each event is typically unique, it will be averaged out during the averaging process. As discussed above, representation **145** will also have a higher effective vertical resolution, due to the lower noise.

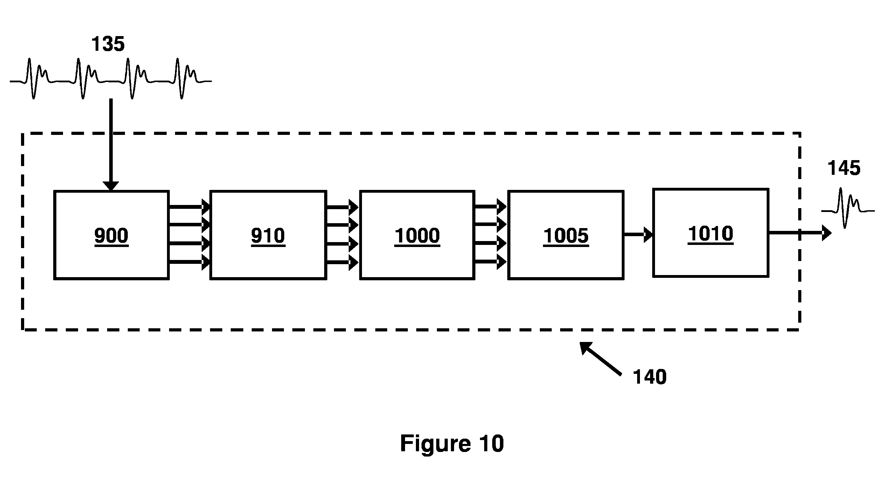

A second method for creating representation **145** may use interleaving instead of averaging, as shown in Figure 10. Note that the specific interleaving steps shown in Figure 10 are for illustration only, and are not intended to limit embodiments of the signal reconstruction block **140.** Any known method of interleaving may be used to create representation **145.**

In Figure 10, event separator **900** and reference position block **910** separate and align the events, as discussed above. In some embodiments, all-pass resampling could also be performed to ensure that the time between interleaved samples is correct. Prior to interleaving, filter array **1000** may be used to correct any aliasing of the events. Filter array **1000** may comprise an array of filters that match the events' relative frequency responses in phase magnitude as a function of frequency. For example, the filters in filter array **1000** may be linear time periodic ("LTP") filters such as standard Multiple-In, Multiple-Out ("MIMO") filters known in the art. Alternatively, a separate bandwidth equalization filter may be applied to each event. By correcting both the phase delays and gain differences between the individual events, the events produced by filter array **1000** will appear to have the same phase and magnitude responses. Filter array **1000** may, however, only perform relative phase and gain corrections. In this case, further filtering may be necessary to correct the absolute phases and magnitudes.

The size of the filter array depends on the type of interleaving that is used. For example, a 4x4 array may be used for 4-way interleaving, while a 2x2 array may be used for 2-way interleaving. Other filter array sizes may also be used, as will be apparent to a person skilled in the art. For example, when filtering four events, two 2x2 filter arrays may be used to interleave the events before averaging the interleaved results, as discussed below.

After the events have been aligned, interleaving block **1005** interleaves the events to create a single event with a higher sample rate. The amount that the sample rate is increased depends on the type of interleaving used. For example, 2-, 3-, or 4-way interleaving increases the sample rate by 2, 3, or 4 times, respectively. The type of interleaving that can be used depends on the number of useful events in series **135.** At least 2, 3, or 4 events are necessary to perform 2-, 3-, and 4-way interleaving, respectively. As discussed above, one or more amplifiers may be used to increase the number of useful events that can be recorded.

Because filter array **1000** only matches relative phases and magnitude responses between the events, the output of interleaving block **1005** may have an incorrect phase and/or magnitude. Bandwidth equalization (BWE EQ) filter **1010** may be used to correct the output of interleaving block **1005** by matching the output's phase and magnitude with a desired target response. The target response typically has a flat magnitude response and a linear phase through the pass band. As a result, BWE EQ filter **1010** outputs representation **145** with a correct phase and magnitude. As discussed above, representation **145** will also have an increased sample rate when compared to each of the sampled events in series **135.**

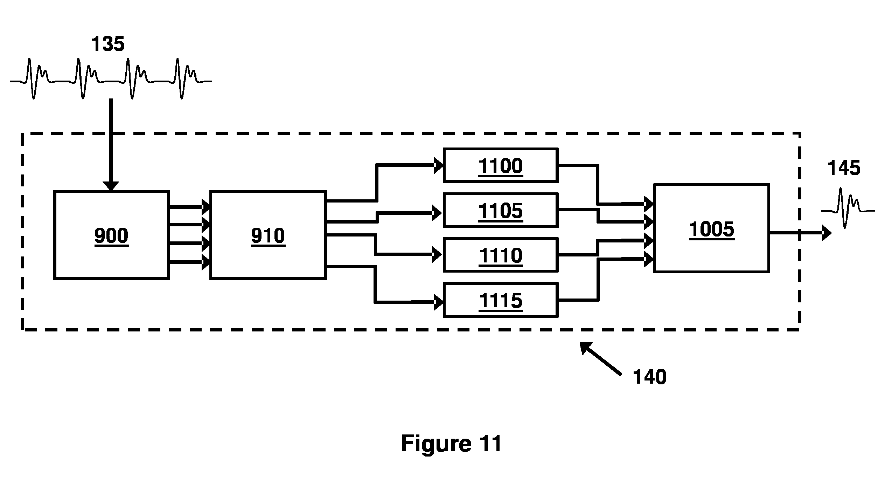

In another embodiment, filter array **1000** may be replaced by a separate bandwidth equalization ("BWE") filter for each event, as depicted in Figure 11. Each of the BWE filters **1100, 1105, 1110,** and **1115,** corrects the phase and magnitude for a single event. Applying a BWE filter to each individual event makes BWE EQ filter **1010** unnecessary. But, because the individual BWE filters do not take aliasing into account, this embodiment may only be possible if the events are not aliased. In contrast, filter array **1000** does take aliasing into account when it filters the individual events. To avoid aliasing, embodiments that use BWE filters **1100, 1105, 1110,** and **1115,** will have a smaller sampling rate increase than embodiments that use filter array **1000.** Thus, filter array **1000** should be used to achieve a larger sampling rate increase, or when the events are aliased.

Other embodiments of reconstruction block **140** may perform both interleaving and averaging. For example, by dividing the events into two or more groups, interleaving the events within each group, and averaging the interleaved results. The resulting representation will have both an increased sample rate due to interleaving and lower noise due to averaging.

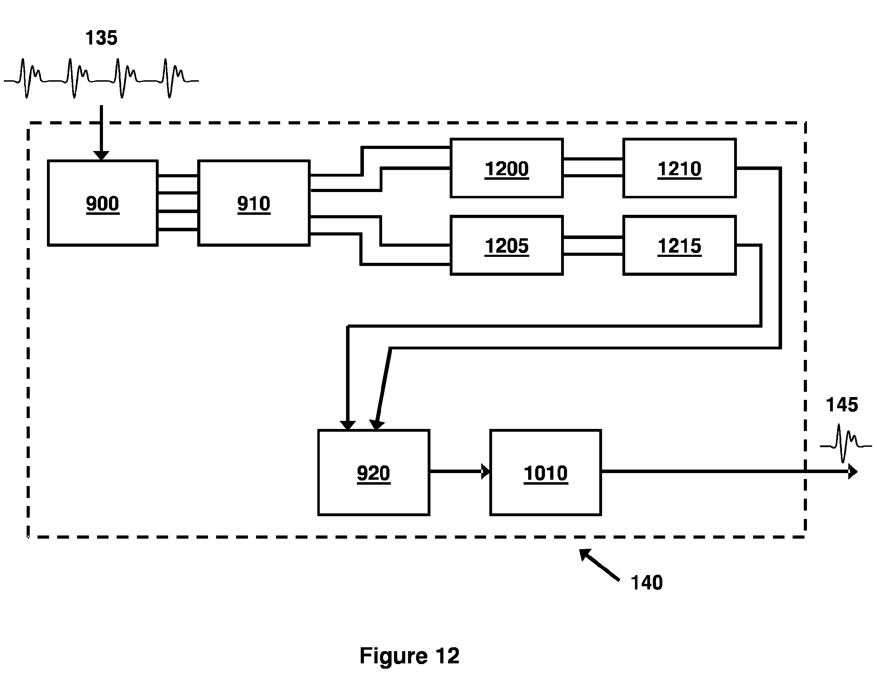

Figure 12 depicts one embodiment that uses both techniques. In this embodiment, the four events in series **135** are divided into two groups of events. Filter arrays **1200** and **1205** apply a 2x2 filter array to the events in each group. Interleaving blocks **1210** and **1215** create two 2-way interleaved results by interleaving the filtered events. As discussed above, each of the interleaved results will have twice the sample rate as the events in series **135.** Averaging block **920** averages the two interleaved results to produce an averaged event that has lower noise than the interleaved results. Finally, bandwidth equalization filter **1010** corrects the phase and magnitude of the averaged result in order to create representation **145.**

Although Figure 12 depicts one possible embodiment for processing four events, this technique could be adapted to process a series containing any even number of events. When series **135** contains an odd number of events however, it may not be possible to combine the averaging and interleaving techniques. In this case, the last event from series **135** may be discarded to create an even number of events. Alternatively, the entire series may be reconstructed by using a single technique.

Because the above-described embodiments can be implemented using existing components, the disclosed solution is relatively inexpensive. Furthermore, the CRD circuitry may be added to the input of an existing instrument with little or no hardware modification. In most cases, the instrument's software can be modified to perform the signal reconstruction. Or, if the instrument is capable of outputting event series **135,** then the signal reconstruction may be performed by another device such as computer, mobile device, or tablet, or a different instrument without any software modification to the first instrument. Thus, the CRD may extend the useful life of an instrument by improving its sampling rate and/or signal-to-noise ratio without a costly upgrade. The CRD may also be implemented internally in the instrument, for example as part of a newly-developed instrument. This would further improve the new instrument's performance with minimal cost.

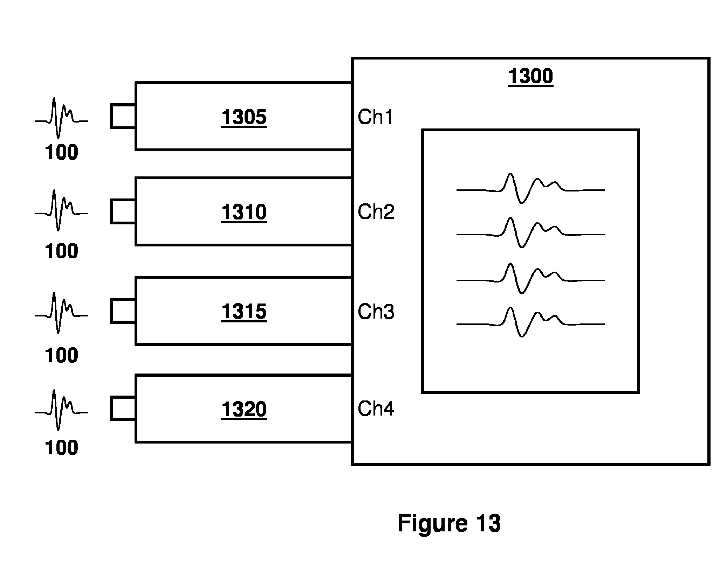

Figure 13 shows an example in which CRD circuitry is added to an existing oscilloscope. In this embodiment, coupling block **110** and delay block **125** may be housed in an add-on box. This would increase the sample rate and resolution, and decrease the noise for each of the individual channels. For example, add-on CRD boxes **1305, 1310, 1315,** and **1320** may each be attached to one or more of the channel inputs on oscilloscope **1300.** The attachment may use a standard connector, such as an existing SMA connector, or a proprietary connector. In this embodiment, digitizer **115** will typically be one or more digitizers already present in oscilloscope **1300.**

Even when add-on boxes are used, some CRD embodiments may require modifications to the instrument. For example, modifications may be necessary to provide a trigger, or to control switches in the CRD, as depicted in Figures 2-9. Likewise, signal reconstruction block **140** is ideally implemented in software residing in oscilloscope **1300.** This may require software changes in oscilloscope **1300,** although in some embodiments these changes may be minimal. For example, reconstruction block **140** may be implemented as Matlab code. Since many existing oscilloscopes are capable of running Matlab code, this would not require changes to any of the oscilloscope's internal software. Only the user Matlab code would need to be modified. In other embodiments, more extensive changes to the software running on the oscilloscope may be needed.

Alternatively, signal reconstruction block **140** could be implemented in a separate device, such as a standard computer, that receives event series **135** from the instrument. This could be useful if the other device is already configured to perform signal reconstruction, or is easier to modify than the instrument. For example, when oscilloscope **1300** does not support Matlab code, and when its software cannot be easily modified.

Examples provide a real-time oscilloscope comprising an external port configured to receive an electrical input signal, a coupling block with first and second inputs and first and second outputs, configured to replicate a signal received at either of the inputs on both of the outputs, wherein the first input of the coupling block is coupled to the external port, a digitizer coupled to the first output of the coupling block, configured to digitize a signal received from the first output in real time, a delay block coupled to the second input and output of the coupling block, configured to delay a signal replicated on the second output and provide the delayed signal to the second input of the coupling block, a memory unit configured to store the digitized signal, and a signal reconstruction block, configured to output a representation of the electrical input signal based on two or more digitized signals.

In some examples the signal reconstruction block comprises an event separator, configured to create one or more individual events based on the digitized signals, one or more equalization filters, configured to remove distortion from the individual events, a reference position block, configured to determine one or more delays for the events, a resampling block, configured to create one or more resampled events by applying one or more of the delays to one or more of the individual events, and an averaging block configured to create the representation of the electrical input signal by averaging one or more of the resampled events.

In some examples the signal reconstruction block comprises an event separator, configured to create one or more individual events based on the digitized signals, a reference position block, configured to determine one or more delays for the events, a filter block, configured to apply a delay to one or more of the events and to match relative frequency responses between two or more events, an interleaving block, configured to create an interleaved event by interleaving two or more of the filtered events, and a bandwidth equalization filter, configured to create the representation of the electrical input signal by correcting a phase and magnitude response for the interleaved event.

In some examples the coupling block comprises a switch and a power divider.

In some examples the coupling block comprises a power splitter and a power divider.

In some examples the coupling block comprises a switch and a power divider.

In some examples the delay block comprises a plurality of delay lines and the oscilloscope is configured to select an appropriate delay line for a given input signal.

Some examples further comprise one or more isolating devices configured to prevent signals from traveling through the system in the wrong direction.

Some examples further comprise one or more amplifiers configured to amplify at least one of the signals.

Some examples further comprise a reset switch configured to dissipate at least one of the signals.

Some examples further comprise a gate coupled to the external input and coupling block, configured to disconnect the electrical input signal from the coupling block based on a trigger event.

Examples provide a method for digitizing an electrical event for use by a real-time instrument, comprising receiving an electrical input signal, creating a replica of the input signal, repeatedly sending the replica through a delay loop, digitizing the replica, to create a digitized signal, after each pass through the delay loop, applying a reconstruction technique to produce an output signal based on two or more digitized signals, and outputting the output signal.

In some examples the step of digitizing the replica after each pass through the delay loop further comprises storing the digitized signal in memory.

In some examples successive replicas are concatenated in memory to create a series of digitized signals.

In some examples the step of applying a reconstruction technique comprises detecting individual events in the series of digitized signals, separating two or more of the individual events, aligning the separated events in time, and producing the output signal based at least in part on the average of two or more aligned events.

Some examples further comprise the step of equalizing one or more of the separated events.

In some examples the step of equalizing the separated events comprises calculating a transfer function for each event, and multiplying one or more of the separated events by the inverse of its transfer function.

In some examples the step of aligning the separated events comprises determining a time vs level reference position for each event, measuring the time from each reference position to a sample clock position, computing an all-pass filter for each event based on the measured time, and applying the all-pass filter for each event, to create aligned events.

In some examples the step of aligning the separated events comprises performing a fast Fourier transform on the separated events, to create FFT events, rotating the phases of the FFT events to align the phases, and performing an inverse fast Fourier transform on the phase-rotated events, to create aligned events.

In some examples the step of applying a reconstruction technique comprises detecting individual events in the series of digitized signals, separating two or more of the individual events, aligning two or more separate events in time, and producing the output events by interleaving two or more aligned events.

Some examples further comprise the step of filtering two or more separate events to match their relative frequency responses in phase magnitude as a function of frequency.

In some examples the step of producing the output further comprises applying a bandwidth enhance equalization filter to the interleaved result.

In some examples the step of applying a reconstruction technique comprises detecting individual events in the series of digitized signals, separating two or more of the individual events, aligning two or more separate events in time, dividing the aligned events into two or more groups, interleaving the events within each group, and producing the output event by averaging the interleaved results.

Although specific embodiments of the invention have been described for purposes of illustration, it will be apparent to those skilled in the art that various modifications may be made without departing from the scope of the invention. For example, all or part of the CRD, digitizer, and reconstruction block may be implemented in one or more of software or hardware located within the instrument or in one or more external devices. Accordingly, the invention should not be limited except as by the appended claims.

## Claims

1. A real-time oscilloscope comprising:
an external port configured to receive an electrical input signal;
a coupling block with first and second inputs and first and second outputs, configured to replicate a signal received at either of the inputs on both of the outputs;
wherein the first input of the coupling block is coupled to the external port;
a digitizer coupled to the first output of the coupling block, configured to digitize a signal received from the first output in real time;
a delay block coupled to the second input and output of the coupling block, configured to delay a signal replicated on the second output and provide the delayed signal to the second input of the coupling block;
a memory unit configured to store the digitized signal; and
a signal reconstruction block, configured to output a representation of the electrical input signal based on two or more digitized signals.

2. The oscilloscope of claim 1, wherein the signal reconstruction block comprises:
an event separator, configured to create one or more individual events based on the digitized signals;
one or more equalization filters, configured to remove distortion from the individual events;
a reference position block, configured to determine one or more delays for the events;
a resampling block, configured to create one or more resampled events by applying one or more of the delays to one or more of the individual events; and
an averaging block configured to create the representation of the electrical input signal by averaging one or more of the resampled events.

3. The oscilloscope of claim 1, wherein the signal reconstruction block comprises:
an event separator, configured to create one or more individual events based on the digitized signals;
a reference position block, configured to determine one or more delays for the events;
a filter block, configured to apply a delay to one or more of the events and to match relative frequency responses between two or more events;
an interleaving block, configured to create an interleaved event by interleaving two or more of the filtered events; and
a bandwidth equalization filter, configured to create the representation of the electrical input signal by correcting a phase and magnitude response for the interleaved event.

4. The oscilloscope of any of claims 1 to 3, wherein the coupling block comprises:
a switch and a power divider; and/or
a power splitter and a power divider.

5. The oscilloscope of any of claims 1 to 4, wherein the delay block comprises a plurality of delay lines and the oscilloscope is configured to select an appropriate delay line for a given input signal.

6. The oscilloscope of any of claims 1 to 5, further comprising:
one or more isolating devices configured to prevent signals from traveling through the system in the wrong direction; and/or
one or more amplifiers configured to amplify at least one of the signals; and/or
a reset switch configured to dissipate at least one of the signals; and/or
a gate coupled to the external input and coupling block, configured to disconnect the electrical input signal from the coupling block based on a trigger event.

7. A method for digitizing an electrical event for use by a real-time instrument, comprising:
receiving an electrical input signal;
creating a replica of the input signal;
repeatedly sending the replica through a delay loop;
digitizing the replica, to create a digitized signal, after each pass through the delay loop;
applying a reconstruction technique to produce an output signal based on two or more digitized signals; and
outputting the output signal.

8. The method of claim 7, wherein;
the step of digitizing the replica after each pass through the delay loop further comprises storing the digitized signal in memory; and
wherein successive replicas are concatenated in memory to create a series of digitized signals.

9. The method of claims 7 or 8, wherein the step of applying a reconstruction technique comprises:
detecting individual events in the series of digitized signals;
separating two or more of the individual events;
aligning the separated events in time; and
producing the output signal based at least in part on the average of two or more aligned events.

10. The method of any of claims 7 to 9, further comprising the step of equalizing one or more of the separated events; and optionally
wherein the step of equalizing the separated events comprises:
calculating a transfer function for each event; and
multiplying one or more of the separated events by the inverse of its transfer function.

11. The method of claim 9, wherein the step of aligning the separated events comprises;
determining a time vs level reference position for each event;
measuring the time from each reference position to a sample clock position; computing an all-pass filter for each event based on the measured time; and applying the all-pass filter for each event, to create aligned events.

12. The method of claim 9, wherein the step of aligning the separated events comprises;
performing a fast Fourier transform on the separated events, to create FFT events;
rotating the phases of the FFT events to align the phases; and
performing an inverse fast Fourier transform on the phase-rotated events, to create aligned events.

13. The method of any of claims 7 to 12, wherein the step of applying a reconstruction technique comprises:
detecting individual events in the series of digitized signals;
separating two or more of the individual events;
aligning two or more separate events in time; and
producing the output events by interleaving two or more aligned events.

14. The method of claim 13, further comprising the step of filtering two or more separate events to match their relative frequency responses in phase magnitude as a function of frequency; and/or
wherein the step of producing the output further comprises applying a bandwidth enhance equalization filter to the interleaved result.

15. The method of any of claims 7 to 14, wherein the step of applying a reconstruction technique comprises:
detecting individual events in the series of digitized signals;
separating two or more of the individual events;
aligning two or more separate events in time;
dividing the aligned events into two or more groups;
interleaving the events within each group; and
producing the output event by averaging the interleaved results.
